# EUROPÄISCHE PATENTSCHRIFT

(11) **EP 3 331 127 B1**
(45) Veröffentlichungstag und Bekanntmachung des Hinweises auf die Patenterteilung: **05.01.2022**
(21) Anmeldenummer: 17201488.8
(22) Anmeldetag: 14.11.2017
(51) Int. Cl.: H02J 11/00, H02J 13/00

(54) **BETRIEBSMITTEL IN EINEM ENERGIENETZ**
RESOURCE IN A GRID
ÉLÉMENT DE FONCTIONNEMENT DANS UN RESEAUX D'ENERGIE

(30) Priorität: 05.12.2016 DE 102016224121
(43) Veröffentlichungstag der Anmeldung: 06.06.2018
(73) Patentinhaber: Siemens Energy Global GmbH & Co. KG, 81739 München (DE)
(72) Erfinder: Bianchi, Roberto, 91056 Erlangen (DE)

(56) Entgegenhaltungen:
- WO-A1-2011/076242
- DE-A1-102012 208 444
- DE-A1-102013 105 444
- US-B2- 8 880 233

## Beschreibung

Die Erfindung betrifft ein Betriebsmittel nach dem Oberbegriff des Anspruch 1.

Energienetzte sind ein wichtiger Teil unserer Infrastruktur und spielen eine zentrale Rolle, sowohl in der Versorgung von Haushalten als auch in der Bereitstellung von Energie für industrielle Anwendungen. Die Verfügbarkeit der Energiezufuhr ist dementsprechend für alle Energiekunden sehr wichtig. Die Verfügbarkeit von Energie wird durch die Verfügbarkeit einer Vielzahl unterschiedlicher Betriebsmittel wie z.B. elektrische Schaltanlagen beeinflusst.

Bisher wurden die meisten Netze mit einer relativ hohen Redundanz ausgelegt. Die Verfügbarkeit des gesamten Netzes ist dementsprechend nicht direkt von einzelnen Betriebsmitteln abhängig, weil im Falle eines Problems ein redundantes Betriebsmittel die Funktion des defekten Betriebsmittels übernehmen kann. Diese Strategie der (N-1) Verfügbarkeit impliziert oft hohe Mehrkosten (z.B. Duplizierung von Hochspannungs-Transformatoren und Hochspannungsanschlüssen). Viele Betreiber von Energienetzen und Betriebsmitteln geraten zunehmend unter wirtschaftlichen Druck, wodurch eine hohe Redundanz nicht mehr flächendeckend gewährleistet werden kann.

Eine Alternative zur redundanten Vorhaltung von Betriebsmitteln ist eine Überwachung des Betriebszustands, insbesondere der Betriebsbereitschaft, mittel sog. Monitoring-Systeme. Diese Systeme sind zentral installiert und empfangen Messwerte der einzelnen Betriebsmittel im Energienetz, anhand derer die Entstehung von Fehlern frühzeitig erkannt und entsprechende Gegenmaßnahmen eingeleitet werden. Beispielsweise kann bei einer gasisolierten Schaltanlage eine Gasdichte des Schutzgases überwacht werden. Somit werden gravierende Störungen vermieden und die Verfügbarkeit des überwachten Betriebsmittels erhöht. Leider sind Monitoring Systeme preisintensiv und deswegen wenig verbreitet. Hinzu kommt, dass für die Nutzung eines Monitoring Systems geschultes Personal erforderlich ist, das die Analysen des Monitoring Systems ständig verfolgt und ggf. Aktionen wie z.B. einen Wartungsauftrag auslöst.

Ausgehend von bisherigen Betriebsmitteln stellt sich an die Erfindung die Aufgabe, ein Betriebsmittel anzugeben, dessen Betriebszustand vergleichsweise einfach und kostengünstig überwachbar ist.

Ein gattungsgemäßes Betriebsmittel ist aus der Druckschrift DE 10 2012 208 444 A1 bekannt.

Die Erfindung löst diese Aufgabe durch ein Betriebsmittel nach Anspruch 1.

Durch den Einsatz der Datenspeichereinrichtung und der Zustandsschätzungseinrichtung direkt vor Ort, also bei dem Betriebsmittel, entfällt die Notwendigkeit eines Zentralen Monitoring bzw. Zustandsüberwachungs-Systems. Das Betriebsmittel wird gewissermaßen mit eigener "Intelligenz" versehen, um sich selbst zu überwachen. Der eigene Zustand wird kontinuierlich beobachtet und bewertet.

Als Datenspeichereinrichtung können alle bekannten Datenspeichermedien eingesetzt werden, beispielsweise Festplatten oder solide-state-discs (SSDs).

Die Zustandsschätzungseinrichtung kann einerseits dafür ausgebildet sein, die aktuellen Messwerte mit vorher festgelegten, bauartbedingten Schwellenwerten zu vergleichen und entsprechend eine Zustandsnachricht auszulösen, wenn die Schwellenwerte unterschritten bzw. überschritten werden. Andererseits kann die Zustandsschätzungseinrichtung anhand der im Datenspeicher gespeicherten Messwerte Trends analysieren und z.B. Prognosen über die zu erwartende Fortentwicklung der Messwerte erstellen. Damit kann bereits eine Zustandsnachricht ausgelöst werden, wenn in naher Zukunft ein Unterschreiten bzw. Überschreiten eines Schwellenwertes zu erwarten ist. Dies ist ein Vorteil, weil die Verfügbarkeit des Betriebsmittels erhöht wird.

Die Zustandsnachricht enthält z.B. den aktuellen und/oder prognostizierten Betriebszustand. Die Zustandsnachricht kann weiterhin detaillierte Informationen wie beispielsweise das Datum der Inbetriebnahme, Hersteller und Typ des Betriebsmittels, Seriennummer, etc. enthalten.

Im Einfachsten Fall übermittelt das Betriebsmittel lediglich eine binäre Information über den Betriebszustand, nämlich z.B. 0 - betriebsbereit und 1 - Wartung erforderlich. Dies ist eine erhebliche Vereinfachung der Handhabung zahlreicher Betriebsmittel für den Betreiber, der bei bisheriger Technik ein vergleichsweise aufwändiges Monitoring-System in Betrieb halten müsste. Bisher werden Sensoren und Monitoring Systeme meist nachgerüstet, was mit erheblichen Aufwänden für die Installation verbunden ist.

Es können je nach Auslegung der Kommunikationsverbindung jedoch auch größere Datenmengen übertragen werden, so dass der Betriebszustand wesentlich detaillierter, z.B. auch nach Baugruppen aufgeschlüsselt, übertragen werden kann. Vorteilhaft ist es insbesondere, wenn jedes Betriebsmittel mit einer eindeutigen Identifizierung, beispielsweise einer herstellerunabhängigen Adresse nach Art einer Mac-Adresse oder einer IP-Adresse, versehen ist und diese in seiner Zustandsnachricht übermittelt.

Die Zustandsnachricht kann im Rahmen des Betriebszustands z.B. die momentane Last, aktuelle Konfiguration, geographische Position, innere bzw. äußere Temperatur sowie aggregierte Daten (z.B. i²t oder Schaltspiele bei einem Leistungsschalter, Trenner oder Erder) enthalten. Ferner können Messwerte wie Teilentladungsstärke oder Gasdichte für Schaltanlagen, "Dissolved Gas" Analysen für Transformatoren usw. direkt in der Zustandsnachricht übermittelt werden. Diese Messwerte stehen dann einem Hersteller oder Wartungsdienstleister zur genauen Auswertung zur Verfügung.

In einer bevorzugten Ausführungsform des erfindungsgemäßen Betriebsmittels ist die Zustandsschätzungseinrichtung dafür ausgebildet, einen zukünftigen Verlauf des Betriebszustands zu prognostizieren.

In einer weiteren bevorzugten Ausführungsform des erfindungsgemäßen Betriebsmittels umfasst das Betriebsmittel eine elektrische Schaltanlage mit einer Motorsteuerung, wobei die Motorsteuerung als Zustandsschätzungseinrichtung ausgebildet ist. Dies ist ein Vorteil, weil die an sich schon eingeplante Motorsteuerung i.d.R. über ausreichende Rechenmittel verfügt, um auch die weitere Funktion der Zustandsschätzung zu übernehmen. Diese Doppelfunktion ist sehr kostengünstig, da im Vergleich zu bisherigen Betriebsmitteln das zusätzliche Vorsehen eines Dateneingangs und eines Datenausgangs genügt. Die Zustandsschätzung kann beispielsweise vollständig in Software umgesetzt werden.

In einer weiteren bevorzugten Ausführungsform des erfindungsgemäßen Betriebsmittels ist die Sensoreinrichtung dafür ausgebildet, mindestens einen der folgenden Messwerte zu erfassen: Strom im Auslösekreis, Anzahl Schalthandlungen eines Trenners oder Erders, Öffnungszeiten eines Leistungsschalters, Gasdruck einer gasisolierten Schaltanlage, Last, innere Temperatur, Temperatur an einer Außenfläche, Umgebungstemperatur.

In einer weiteren bevorzugten Ausführungsform des erfindungsgemäßen Betriebsmittels ist das Betriebsmittel zur Archivierung aller erfassten Messwerte nach Art eines Flugschreibers ausgebildet, so dass Fehler anhand einer kompletten Betriebsmittelhistorie nachvollzogen und analysiert werden können. Dafür wird der Datenspeicher verwendet. Zusätzlich können auch noch alle ermittelten Betriebszustände gespeichert werden. Die Speicherung von Messwerten und ggf. Betriebszuständen ist ein Vorteil, weil durch den Betreiber oder Hersteller anhand der vollständigen Daten-Historie Schlüsse für eine Verbesserung zukünftiger Betriebsmittel geschlossen werden können. Die Daten können entweder beim Austausch des Geräts ausgelesen oder auch im Betrieb mittels der Kommunikationseinrichtung abgerufen werden. Bisher ist es für Hersteller von Betriebsmitteln kaum möglich, solche vollständigen Informationen über die gesamte Lebensdauer des Betriebsmittels hinweg zu sammeln, anhand derer sich Schwachstellen der Technik erkennen lassen. Entsprechend der Funktionsweise eines Flugschreibers und je nach Datenspeicherkapazität des Datenspeichers kann beispielsweise ein Zeitfenster von einigen Wochen aus der Vergangenheit komplett abgespeichert werden.

In einer weiteren bevorzugten Ausführungsform des erfindungsgemäßen Betriebsmittels ist die Kommunikationseinrichtung zur Bereitstellung einer Datenkommunikation über mindestens eines der folgenden Verfahren ausgebildet: W-LAN, LAN, Mobilfunk, Powerline Communication, Bluetooth, 6LoWPAN.

Die Zustandsschätzungseinrichtung ist ausgebildet, anhand des Betriebszustands eine notwendige Wartung des Betriebsmittels zu erkennen und eine Zustandsnachricht mittels der Kommunikationseinrichtung für einen Betreiber des Betriebsmittels und/oder für einen Wartungsdienstleister bereit zu stellen. Der Betreiber des Betriebsmittels ist beispielsweise ein Energieversorger oder Verteilnetzbe-treiber. Ein Wartungsdienstleister kann beispielsweise auch einem Hersteller zugeordnet sein. Die Zustandsnachricht kann bei einem sich verschlechternden Betriebszustand beispielsweise durch einen Überlastbetrieb, das Erreichen der mechanischen Höchstlebensdauer oder ein Gas-Leck mit entsprechendem Druckabfall ausgelöst sein.

Das "intelligente" Betriebsmittel ist im Vergleich dazu sehr kostengünstig, weil es als zusätzliche Funktionalität bei großer Stückzahl von Betriebsmitteln schon ab Werk sehr kostengünstig eingebaut werden kann. Es stellt letztendlich eine Verschmelzung von Primär- und Sekundärtechnik mit einem Monitoring dar.

In einer weiteren bevorzugten Ausführungsform des erfindungsgemäßen Betriebsmittels ist das Betriebsmittel ausgebildet, eine Zustandsnachricht eines anderen Betriebsmittels zu empfangen und weiterzuleiten. Dies ist ein Vorteil, weil auf diese Weise auch in Gebieten ohne Funkverbindung nicht auf extra zu installierende Kabelverbindungen oder Powerline-Communication zurückgegriffen werden muss, sondern die Betriebsmitteln füreinander als Netzwerk funktionieren.

In einer weiteren bevorzugten Ausführungsform des erfindungsgemäßen Betriebsmittels weist das Betriebsmittel eine Positionserkennungseinrichtung zur Bestimmung der geographischen Position des Betriebsmittels auf. Dies ist ein Vorteil, weil das Betriebsmittel den Installationsort in der Zustandsnachricht übermitteln kann und damit die Wartung durch einen Dienstleister oder durch den Hersteller erleichtert.

In einer weiteren bevorzugten Ausführungsform des erfindungsgemäßen Betriebsmittels übermittelt das Betriebsmittel seine geographische Position. Dies ist ein Vorteil, weil das Betriebsmittel den Installationsort beispielsweise bei der Installation am Betriebsort eingespeichert erhält und diese Position dann, beispielsweise bei einer Meldung über eine erforderliche Wartung, mit übermitteln kann.

In einer weiteren bevorzugten Ausführungsform des erfindungsgemäßen Betriebsmittels weist das Betriebsmittel einen Leistungsschalter auf.

In einer weiteren bevorzugten Ausführungsform des erfindungsgemäßen Betriebsmittels weist das Betriebsmittel einen Transformator auf.

In einer weiteren bevorzugten Ausführungsform des erfindungsgemäßen Betriebsmittels weist das Betriebsmittel ein flexibles Drehstromübertragungssystem (FACTS) auf.

In einer weiteren bevorzugten Ausführungsform des erfindungsgemäßen Betriebsmittels weist das Betriebsmittel ein Schutzgerät auf.

In einer weiteren bevorzugten Ausführungsform des erfindungsgemäßen Betriebsmittels ist mindestens eine weitere Sensoreinrichtung mit einem zugeordneten weiteren Datenspeicher vorgesehen. Dies ist ein Vorteil, weil mehrere Baugruppen separat mittels eines Sensors und Datenspeichers überwacht werden können. Eine solche Modulbauweise gestattet häufig eine vereinfachte Interoperabilität zwischen verschiedenen Varianten eines Betriebsmittels. Dabei können die Daten beispielsweise in einer gemeinsamen Zustandsschätzungseinrichtung ausgewertet werden.

Zur besseren Erläuterung der Erfindung zeigen die
- Figur 1: ein erfindungsgemäßes Betriebsmittel und
- Figur 2: eine Anordnung mit mehreren Betriebsmitteln.

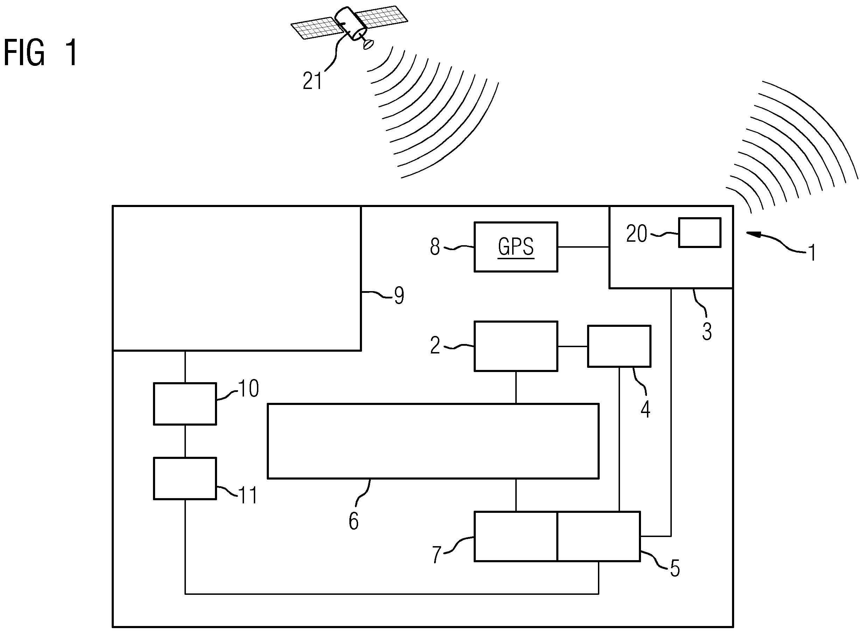

Die Figur 1 zeigt ein erfindungsgemäßes Betriebsmittel 1. Das Betriebsmittel 1 weist eine elektrische Schaltanlage 6 mit einer Motorsteuerung 7 auf. Die elektrische Schaltanlage 6 wird mit einer Sensoreinrichtung 2 überwacht. Die Sensoreinrichtung 2 erfasst Messwerte wie beispielsweise eine Temperatur in der Schaltanlage 6, Anzahl der Schalthandlungen und Öffnungszeiten des Leistungsschalters. Die gesammelten Messwerte werden in einem Datenspeicher 4, der als herkömmliche Festplatte ausgebildet ist, archiviert. Der Datenspeicher erfasst nach Art eines Flugschreibers die komplette Messwerthistorie des Betriebsmittels, so dass diese für weitergehende Analysen genutzt werden kann.

Die Messwerte werden in einer Zustandsschätzungseinrichtung 5 ausgewertet, die ein Teil der Motorsteuerung 7 ist. Die Zustandsschätzungseinrichtung 5 kann beispielsweise als eine Softwarekomponente innerhalb der Motorsteuerung vorgesehen werden. Die Zustandsschätzungseinrichtung 5 ermittelt anhand der erfassten Messwerte den Betriebszustand der elektrischen Schaltanlage 5. Hieraus wird eine Zustandsnachricht 20 erzeugt, die mittels einer Kommunikationseinrichtung 3 beispielsweise über eine Funkverbindung versendet werden kann. Die Zustandsnachricht 20 enthält zumindest eine Information über den aktuellen Betriebszustand, also beispielsweise im einfachsten Fall ein binäres Signal. In diesem Fall enthält die Zustandsnachricht beispielsweise den Wert 0 für betriebsbereit und 1 für Wartung erforderlich. Die Zustandsnachricht kann entweder nur im Fehlerfall versandt oder es kann eine periodische Übermittlung des Betriebszustands erfolgen. Die periodische Übermittlung, also beispielsweise mit einer Zustandsnachricht pro Tag, hat den Vorteil, dass ein Betreiber auch stets die positive Information über die Betriebsbereitschaft seiner Betriebsmittel empfängt.

Weiterhin ist eine Positionserkennungseinrichtung 8 vorgesehen, die mittels GPS-Informationen, die von einem Satelliten 21 empfangen werden, die aktuelle Position des Betriebsmittels 1 feststellen kann. Der Zustandsnachricht 20 kann dann jeweils eine Positionsinformation hinzugefügt werden, so dass auch die Position des Betriebsmittels 1 übermittelt wird.

Ferner kann die Zustandsnachricht 20 weitere Details zum Betriebszustand oder einzelnen Messwerten enthalten. Auch kann eine Prognose des zu erwartenden Betriebszustands mittels der Zustandsschätzungseinrichtung ermittelt und über die Kommunikationseinrichtung 3 versendet werden. Vorteilhaft ist es weiterhin, wenn über die Zustandsschätzungseinrichtung 5 auch eine Identifikation des Betriebsmittels in die Nachricht 20 eingefügt wird, also beispielsweise Seriennummer, Hersteller und Typ des Betriebsmittels. Denkbar und voreilhaft ist auch eine eindeutige Nummer wie beispielsweise eine "media-accesscontrol" (MAC) -Adresse, die Herstellerunabhängig bereits ab Werk an alle Betriebsmittel vergeben wurde. Alternativ kann auch eine IP-Adresse eingesetzt werden, diese muss jedoch dem Kundennetz angepasst werden, um eine eindeutige Zuordnung zu gestatten.

Das gezeigte Betriebsmittel 1 weist eine weitere Baugruppe 9 auf, die mit einer weiteren Sensoreinrichtung 10 und einem weiteren Datenspeicher 11 verbunden ist. Diese Baugruppe 9 wird damit separat überwacht, wobei die Auswertung der Messwerte auch der Baugruppe 9 durch die Zustandsschätzungseinrichtung 5 erfolgt. Diese kann dann entweder einen Gesamtbetriebszustand ermitteln oder zwei unterschiedliche Betriebszustände für die elektrische Schaltanlage 6 und die weitere Baugruppe 9 bereitstellen und übermitteln.

Es ist ein wesentlicher Vorteil des vorliegenden Betriebsmittels, dass die im Rahmen der Motorsteuerung 7 bereits vorhandene Intelligenz eines Betriebsmittels ausgenutzt wird, um vor Ort eine autonome Zustandsüberwachung durchzuführen. Die Notwendigkeit, alle Messwerte an eine zentrale Auswerteeinrichtung wie ein Monitoring System zu übertragen und dort zu analysieren, entfällt. Jedes Betriebsmittel dieser Bauart kann sich selbst überwachen und ein einfaches Wartungssignal an den Betreiber des Betriebsmittel oder einen Wartungsdienstleister absetzen, falls dies erforderlich ist. Die Notwendigkeit zur Vorhaltung aufwändiger Condition Monitoring Systeme und entsprechend geschulten Personals entfällt, weil jedes Betriebsmittel herstellseitig bereits mit einer eigenen, vollintegrierten Zustandsüberwachung versehen wird.

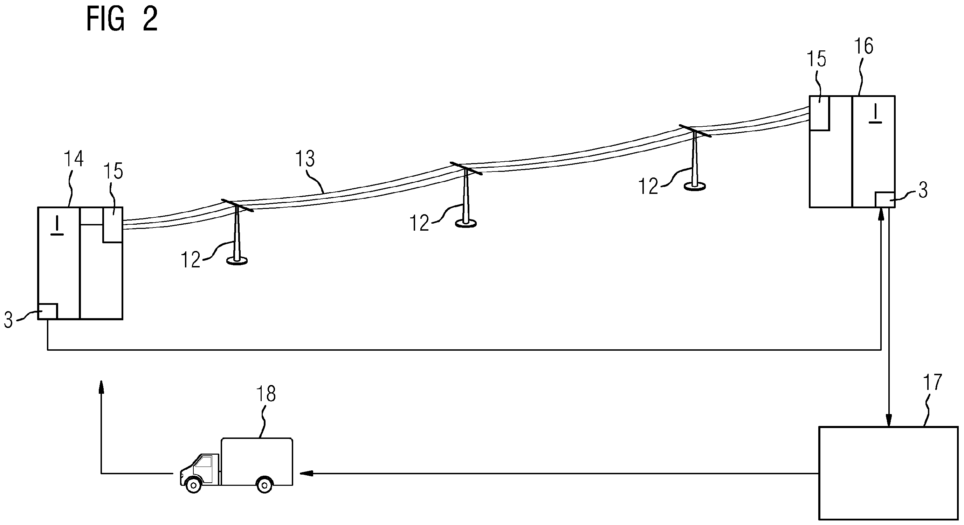

Die Figur 2 zeigt eine Anordnung mit drei Hochspannungsmasten 12 und Freileitungen 13, die zwei Schaltwerke 14 und 16 miteinander verbinden. Beide Schaltwerke 14, 16 weisen jeweils einen Transformator 15 und ein erfindungsgemäßes Betriebsmittel 1 mit Kommunikationseinrichtung 3 auf. In dieser Ausführungsform sind die Betriebsmittel dafür ausgebildet, Zustandsnachrichten weiterer Betriebsmittel über deren Kommunikationseinrichtungen 3 zu empfangen und diese an eine zentrale Auswerteeinrichtung 17 beim Betreiber oder Wartungsdienstleister weiterzugeben. Die zentrale Auswerteeinrichtung 17 empfängt im gezeigten Beispiel eine Zustandsnachricht des Schaltwerks 14, welches über das Schaltwerk 16 weitergeleitet wurde. Die Zustandsnachricht enthält eine Wartungsanfrage, so dass die zentrale Auswerteeinrichtung 17 ein Wartungsteam 18 zum Schaltwerk 14 senden kann.

## Patentansprüche

1. Betriebsmittel (1) mit
- einer Sensoreinrichtung (2) für das Erfassen von Messwerten,
- einer Kommunikationseinrichtung (3) für die Übermittlung einer Zustandsnachricht,
- einer Datenspeichereinrichtung (4) für das Speichern der erfassten Messwerte,
- eine Zustandsschätzungseinrichtung (5) für ein Ermitteln eines Betriebszustands anhand der erfassten Messwerte, **dadurch gekennzeichnet, dass**
die Zustandsschätzungseinrichtung (5) ausgebildet ist, anhand des Betriebszustands eine notwendige Wartung des Betriebsmittels (1) zu erkennen und eine Zustandsnachricht (20) mittels der Kommunikationseinrichtung (3) für einen Betreiber des Betriebsmittels (1) und/oder für einen Wartungsdienstleister (17) bereit zu stellen.

2. Betriebsmittel (1) nach Anspruch 1, **dadurch gekennzeichnet, dass** die Zustandsschätzungseinrichtung (5) dafür ausgebildet ist, einen zukünftigen Verlauf des Betriebszustands zu prognostizieren.

3. Betriebsmittel (1) nach Anspruch 1 oder 2, **dadurch gekennzeichnet, dass** das Betriebsmittel (1) eine elektrische Schaltanlage (6) mit einer Motorsteuerung (7) umfasst, wobei die Motorsteuerung (7) als Zustandsschätzungseinrichtung (5) ausgebildet ist.

4. Betriebsmittel (1) nach einem der vorhergehenden Ansprüche, **dadurch gekennzeichnet, dass** die Sensoreinrichtung (2) dafür ausgebildet ist, mindestens einen der folgenden Messwerte zu erfassen: Strom im Auslösekreis, Anzahl Schalthandlungen eines Trenners oder Erders, Öffnungszeiten eines Leistungsschalters, Gasdruck einer gasisolierten Schaltanlage, Last, innere Temperatur, Temperatur an einer Außenfläche, Umgebungstemperatur.

5. Betriebsmittel (1) nach einem der vorhergehenden Ansprüche, **dadurch gekennzeichnet, dass** das Betriebsmittel (1) zur Archivierung aller erfassten Messwerte nach Art eines Flugschreibers ausgebildet ist, so dass Fehler anhand einer kompletten Messwerthistorie nachvollzogen und analysiert werden können.

6. Betriebsmittel (1) nach einem der vorhergehenden Ansprüche, **dadurch gekennzeichnet, dass** die Kommunikationseinrichtung (3) zur Bereitstellung einer Datenkommunikation über mindestens eines der folgenden Verfahren ausgebildet ist: W-LAN, LAN, Mobilfunk, Powerline Communication, Bluetooth, 6LoWPAN.

7. Betriebsmittel (1) nach einem der vorhergehenden Ansprüche, **dadurch gekennzeichnet, dass** das Betriebsmittel (1) ausgebildet ist, eine Zustandsnachricht (20) eines anderen Betriebsmittels (1) zu empfangen und weiterzuleiten.

8. Betriebsmittel (1) nach einem der vorhergehenden Ansprüche, **dadurch gekennzeichnet, dass** das Betriebsmittel (1) eine Positionserkennungseinrichtung (20) zur Bestimmung der geographischen Position des Betriebsmittels (1) aufweist.

9. Betriebsmittel (1) nach einem der vorhergehenden Ansprüche, **dadurch gekennzeichnet, dass** das Betriebsmittel (1) einen Leistungsschalter (6) aufweist.

10. Betriebsmittel (1) nach einem der vorhergehenden Ansprüche, **dadurch gekennzeichnet, dass** das Betriebsmittel (1) einen Transformator (15) aufweist.

11. Betriebsmittel (1) nach einem der vorhergehenden Ansprüche, **dadurch gekennzeichnet, dass** das Betriebsmittel (1) ein flexibles Drehstromübertragungssystem (FACTS) aufweist.

12. Betriebsmittel (1) nach einem der vorhergehenden Ansprüche, **dadurch gekennzeichnet, dass** das Betriebsmittel (1) ein Schutzgerät aufweist.

13. Betriebsmittel (1) nach einem der vorhergehenden Ansprüche, **dadurch gekennzeichnet, dass** mindestens eine weitere Sensoreinrichtung (10) mit einem zugeordneten weiteren Datenspeicher (11) vorgesehen ist.

## Claims

1. Operating means (1) having
- a sensor device (2) for recording measurement values,
- a communication device (3) for transmitting a status report,
- a data storage device (4) for storing the recorded measurement values,
- a status estimation device (5) for determining an operating status with the aid of the recorded measurement values, **characterized in that**
the status estimation device (5) is configured to identify required maintenance of the operating means (1) with the aid of the operating status, and to provide a status report (20) by means of the communication device (3) for an operator of the operating means (1) and/or for a maintenance service provider (17).

2. Operating means (1) according to Claim 1, **characterized in that** the status estimation device (5) is configured to predict a future profile of the operating status.

3. Operating means (1) according to Claim 1 or 2, **characterized in that** the operating means (1) comprises an electrical switchgear (6) having a motor controller (7), the motor controller (7) being configured as a status estimation device (5).

4. Operating means (1) according to one of the preceding claims, **characterized in that** the sensor device (2) is configured to record at least one of the following measurement values: current in the trip circuit, number of switching actions of a disconnector or earth electrode, opening times of a power switch, gas pressure of a gas-insulated switchgear, load, internal temperature, temperature on an external surface, ambient temperature.

5. Operating means (1) according to one of the preceding claims, **characterized in that** the operating means (1) is configured to archive all recorded measurement values in the manner of a flight recorder, so that faults can be traced and analysed with the aid of a complete measurement value history.

6. Operating means (1) according to one of the preceding claims, **characterized in that** the communication device (3) is configured to provide data communication by means of at least one of the following methods: WLAN, LAN, mobile telephony, powerline communication, Bluetooth, 6LoWPAN.

7. Operating means (1) according to one of the preceding claims, **characterized in that** the operating means (1) is configured to receive and forward a status report (20) of another operating means (1).

8. Operating means (1) according to one of the preceding claims, **characterized in that** the operating means (1) comprises a position detection device (20) for determining the geographical position of the operating means (1).

9. Operating means (1) according to one of the preceding claims, **characterized in that** the operating means (1) comprises a power switch (6).

10. Operating means (1) according to one of the preceding claims, **characterized in that** the operating means (1) comprises a transformer (15).

11. Operating means (1) according to one of the preceding claims, **characterized in that** the operating means (1) comprises a flexible alternating-current transmission system (FACTS).

12. Operating means (1) according to one of the preceding claims, **characterized in that** the operating means (1) comprises a protective unit.

13. Operating means (1) according to one of the preceding claims, **characterized in that** at least one further sensor device (10) having an associated further data memory (11) is provided.

## Revendications

1. Moyen (1) de fonctionnement comprenant
- un dispositif (2) de capteur pour le relevé de valeurs de mesure,
- un dispositif (3) de communication pour la transmission d'un message d'état,
- un dispositif (4) de mise en mémoire de données pour la mise en mémoire des valeurs de mesure relevées,
- un dispositif (5) d'évaluation d'état pour une détermination d'un état de fonctionnement à l'aide des valeurs de mesure relevées,
**caractérisé en ce que**
le dispositif (5) d'évaluation d'état est constitué pour détecter à l'aide de l'état de fonctionnement la nécessité d'un entretien du moyen de fonctionnement et pour mettre au moyen du dispositif (3) de communication un message (20) d'état à disposition d'un opérateur du moyen (1) de fonctionnement et/ou d'un prestataire (17) de services d'entretien.

2. Moyen (1) de fonctionnement suivant la revendication 1, **caractérisé en ce que** le dispositif (5) d'estimation d'état est constitué pour pronostiquer une variation à venir de l'état de fonctionnement.

3. Moyen (1) de fonctionnement suivant la revendication 1 ou 2, **caractérisé en ce que** le moyen de fonctionnement comprend une installation (6) électrique de commutation ayant une commande (7) de moteur, la commande (7) de moteur étant constituée en dispositif (5) d'évaluation d'état.

4. Moyen (1) de fonctionnement suivant l'une des revendications précédentes, **caractérisé en ce que** le dispositif (2) de capteur est constitué pour relever au moins l'une des valeurs de mesure suivantes : courant dans le circuit de déclenchement, nombre de manipulations de commutation d'un sectionneur ou d'un dispositif de mise à la terre, temps d'ouverture d'un disjoncteur, pression du gaz d'une installation de distribution isolée par du gaz, charge, température intérieure, température d'une surface extérieure, température ambiante.

5. Moyen (1) de fonctionnement suivant l'une des revendications précédentes, **caractérisé en ce que** le moyen (1) de fonctionnement est constitué pour l'archivage de toutes les valeurs de mesure relevées à la manière d'un enregistreur de vol de manière à pouvoir reconstruire et analyser des défauts à l'aide d'un historique complet de valeurs de mesure.

6. Moyen (1) de fonctionnement suivant l'une des revendications précédentes, **caractérisé en ce que** le dispositif (3) de communication est constitué pour disposer d'une communication de données par au moins l'un des procédés suivants : W-LAN, LAN, téléphonie mobile, Powerline Communication, Bluetooh, 6LoWPAN.

7. Moyen (1) de fonctionnement suivant l'une des revendications précédentes, **caractérisé en ce que** le moyen (1) de fonctionnement est constitué pour recevoir et acheminer un message (20) d'état d'un autre moyen (1) de fonctionnement.

8. Moyen (1) de fonctionnement suivant l'une des revendications précédentes, **caractérisé en ce que** le moyen de fonctionnement a un dispositif (20) de détection de position pour la détermination de la position géographique du moyen (1) de fonctionnement.

9. Moyen (1) de fonctionnement suivant l'une des revendications précédentes, **caractérisé en ce que** le moyen de fonctionnement a un disjoncteur (6).

10. Moyen (1) de fonctionnement suivant l'une des revendications précédentes, **caractérisé en ce que** le moyen de fonctionnement a un transformateur (15).

11. Moyen (1) de fonctionnement suivant l'une des revendications précédentes, **caractérisé en ce que** le moyen (1) de fonctionnement a un système souple de transport de courant triphasé (FACTS).

12. Moyen (1) de fonctionnement suivant l'une des revendications précédentes, **caractérisé en ce que** le moyen (1) de fonctionnement a un appareil de protection.

13. Moyen (1) de fonctionnement suivant l'une des revendications précédentes, **caractérisé en ce qu'**il est prévu au moins un autre dispositif (10) de capteur ayant une autre mémoire (11) de données associée.
